# EUROPÄISCHE PATENTANMELDUNG

(11) **EP 1 213 615 A2**
(43) Veröffentlichungstag der Anmeldung: **12.06.2002**
(21) Anmeldenummer: 01126754.9
(22) Anmeldetag: 09.11.2001
(51) Int. Cl.: G03F 1/00

(54) **Fotoempfindliches flexographisches Druckelement mit mindestens zwei IR-ablativen Schichten**

(30) Priorität: 07.12.2000 DE 10061116
(71) Anmelder: BASF Drucksysteme GmbH, 70469 Stuttgart (DE)
(72) Erfinder: Kaczun, Jürgen, Dr., 67150 Niederkirchen (DE); Philipp, Sabine, Dr., 64546 Mörfelden-Walldorf (DE)
(74) Vertreter: Wicke, Reinhard, Dr.

(57) **Zusammenfassung**

Fotoempfindliches Flexodruckelement zur Herstellung von Flexodruckformen durch digitale Bebilderung mittels Lasern, welches eine Kombination von mindestens zwei verschiedenen IR-ablativen Schichten umfasst, wobei die eine Schicht ein elastomeres Bindemittel und die andere ein selbstzersetzliches Bindemittel umfasst. Verfahren zur Herstellung von Flexodruckplatten unter Verwendung eines derartigen Elementes.

## Beschreibung

Die Erfindung betrifft ein fotoempfindliches Flexodruckelement zur Herstellung von Flexodruckformen durch digitale Bebilderung mittels Lasern, welches eine Kombination von mindestens zwei verschiedenen IR-ablativen Schichten umfasst, wobei die eine Schicht ein elastomeres Bindemittel und die andere ein selbstzersetzliches Bindemittel umfasst. Weiterhin betrifft die Erfindung ein Verfahren zur Herstellung von Flexodruckplatten unter Verwendung eines derartigen Elementes.

Die konventionelle Technik zur Herstellung von Flexodruckplatten durch Auflegen einer fotografischen Maske auf ein fotopolymeres Aufzeichnungselement, Bestrahlen mit aktinischem Licht durch diese Maske sowie Auswaschen der nicht polymerisierten Bereiche des belichteten Elementes mit einer Entwicklerflüssigkeit wird zunehmend durch CtP-Technologien (computer-to-plate-technology), häufig auch als digitale Bebilderung bezeichnet, abgelöst. Bei CtP-Techniken wird die fotografische Maske konventioneller Systeme durch in das Aufzeichnungselement integrierte Masken ersetzt.

Obwohl eine Reihe verschiedener Techniken vorgeschlagen worden sind, haben bislang nur zwei Techniken am Markt größere Bedeutung erlangt. Bei der einen Technik wird das fotopolymerisierbare Element mit einer geeigneten Farbaufnahmeschicht versehen und eine Maske mittels eines Ink-Jet-Druckers aufgedruckt, wie beispielsweise offenbart von WO 97/25206. Anschließend kann das Element in bekannter Art und Weise belichtet und entwickelt werden.

Bei der zweiten Technik wird das fotopolymerisierbare Element mit einer weitgehend opaken, IR-ablativen Schicht beschichtet. Derartige Schichten enthalten üblicherweise Ruß. Durch bildmäßiges Bestrahlen mittels eines Lasers wird die IR-ablative Schicht an den Stellen entfernt, an denen sie vom Laserstrahl getroffen wird und die darunter liegende fotopolymerisierbare Schicht wird freigelegt. Danach kann das bebilderte Aufzeichnungselement durch die ablativ gebildete Maske in bekannter Art und Weise vollflächig mit aktinischem Licht bestrahlt und mit einer Entwicklerflüssigkeit ausgewaschen werden. Bei dem Auswaschschritt werden die nicht ablatierten Reste der IR-ablativen Schicht sowie die sich darunter befindlichen nicht polymerisierten Bereiche des belichteten Elementes entfernt.

Flexodruckelemente mit IR-ablativen Schichten sind prinzipiell bekannt. EP-A 654 150 offenbart ein flexografisches Druckelement mit einer IR-ablativen Schicht. Die IR-ablative Schicht umfasst ein IR-absorbierendes Material. Außerdem sind als optionale Bestandteile polymere Bindemittel sowie eine große Anzahl verschiedenster Hilfsmittel wie beispielsweise Dispergierhilfsmittel oder Weichmacher offenbart. Des Weiteren ist eine zusätzliche Sperrschicht zwischen der fotopolymerisierbaren Schicht und der IR-ablativen Schicht offenbart. Diese soll die Diffusion von Monomeren aus der fotopolymerisierbaren in die IR-ablative Schicht verhindern. EP-A 654 150 offenbart auch, dass prinzipiell mehr als eine IR-ablative Schicht vorhanden sein kann.

EP-A 741 330 offenbart ein IR-ablatives Flexodruckelement, welches keine derartige Sperrschicht aufweist. Als Bindemittel für die IR-ablative Schicht sind eine Vielzahl verschiedenster Polymere offenbart. Weiterhin kann die IR-ablative Schicht auch ein zweites Bindemittel in geringerer Menge umfassen, für das ebenfalls eine Vielzahl verschiedenster Polymere offenbart sind.

EP-A 908 778 offenbart ein flexografisches Druckelement, welches eine SIS- oder SBS-Blockcopolymere enthaltende IR-ablative Schicht aufweist.

EP-A 767 407 offenbart ein flexografisches Druckelement mit einer IR-ablativen Schicht, die ein elastomeres, filmbildendes Bindemittel aufweist. Als Bindemittel sind Polyamide sowie Polyvinylalkohol-Polyethylenglykol-Propfcopolymere offenbart.

Beim Verfahren zur Herstellung von Flexodruckplatten durch IR-Ablation ist die Qualität der IR-ablativen Schicht der entscheidende Parameter für die Qualität der Flexodruckplatte und die Wirtschaftlichkeit des Verfahrens. Die IR-ablative Schicht muss eine Reihe verschiedenster Qualitätskriterien erfüllen:
- Sie soll eine hohe Empfindlichkeit für Laser besitzen, um eine schnelle und vollständige Entfernung der Schicht bei möglichst geringer Laserleistung zu gewährleisten.
- Sie soll in konventionellen Auswaschmitteln für die fotopolymerisierbare Schicht löslich sein, damit sie im Zuge des üblichen Entwicklungsschrittes zusammen mit den nicht polymerisierten Bestandteilen der Schicht entfernt werden kann. Anderenfalls müssten zwei Auswaschschritte durchgeführt werden.
- Bei den heutzutage verwendeten Laserapparaturen handelt es sich üblicherweise um Geräte mit rotierenden Trommeln (Aussen- oder Innentrommel). Die IR-ablative Schicht muss daher elastisch sein, damit sie beim Aufspannen auf die Trommel nicht reisst oder runzelt.
- Sie muss klebfrei sein, damit kein Staub angezogen wird, der die IR-Ablation stören könnte.
- Für Lagerung und Transport werden Flexodruckelemente üblicherweise mit einer Schutzfolie vor Beschädigung geschützt, die vor der IR-Ablation abgezogen werden muss. Die Schutzfolie darf nur leicht an der IR-ablativen Schicht haften, damit beim Abziehen die IR-ablative Schicht nicht beschädigt wird.
- Umgekehrt muss die IR-ablative Schicht stark auf der lichtempfindlichen Schicht haften, damit sie beim Abziehen der Schutzfolie nicht mit abgezogen wird und damit keine Lufteinschlüsse den Vorteil des direkten Kontaktes zwischen IR-ablativer Schicht und fotopolymerisierbarer Schicht zunichte machen.

Der Fachmann, der ein hochempfindliches, qualitativ hochwertiges Flexodruckelement mit IR-ablativer Schicht bereitstellen möchte, sieht sich mit einer typischen Scherensituation konfrontiert. Um eine möglichst empfindliche IR-ablative Schicht zu erhalten, ist die Verwendung eines selbstoxidativen/selbstzersetzlichen Bindemittels wie Nitrocellulose empfehlenswert. Nitrocellulose-Schichten sind aber sehr spröde, so dass die Elastizität von Nitrocellulose-Schichten zu wünschen übrig lässt und derartige Flexodrukkelemente beim Aufspannen auf Trommelgeräte leicht reissen und runzeln. Zwar lässt sich die Sprödigkeit durch Zusatz von geeigneten Weichmachern vermindern, aber der Zusatz von Weichmachern hat häufig klebrige Schichten mit zu hoher Deckfolienhaftung zur Folge. Typische klebfreie Bindemittel, wie beispielsweise bestimmte Polyamide weisen jedoch eine deutlich geringere Empfindlichkeit auf.

Aufgabe der Erfindung war es, ein flexografisches Druckelement bereitzustellen, dessen IR-ablative Schicht einen möglichst hohen Anteil an selbst zersetzlichen Bindemitteln aufweist und dennoch die oben genannten Anforderungen erfüllt.

Überraschenderweise wurde gefunden, dass dieses Ziel durch eine Kombination von mindestens zwei verschiedenen IR-ablativen Schichten erreicht werden kann.

Dementsprechend wurde ein fotoempfindliches Flexodruckelement zur Herstellung von Flexodruckformen durch digitale Bebilderung mittels Lasern gefunden, welches mindestens
- einen dimensionsstabilen Träger,
- eine fotopolymerisierbare Schicht, mindestens umfassend ein elastomeres Bindemittel, eine polymerisierbare Verbindung und einen Fotoinitiator oder ein Fotoinitiatorsystem,
- mindestens zwei laser-ablatierbare Schichten A und B, die jeweils mindestens ein Bindemittel sowie einen IR-Absorber für Laserstrahlung aufweisen, sowie
- optional eine abziehbare, flexible Schutzfolie,
umfasst, wobei es sich bei dem mindestens einen Bindemittel der Schicht A um ein elastomeres Bindemittel und dem mindestens einen Bindemittel der Schicht B um ein selbst-zersetzliches Bindemittel handelt und die optische Dichte der gesamten Schichtenfolge IR ablative Schichten im aktinischen Spektralbereich mindestens 2,5 beträgt.

Weiterhin wurde ein Verfahren zur Herstellung von Flexodruckplatten unter Verwendung eines derartigen Elementes gefunden.

Zu der Erfindung ist im Einzelnen Folgendes auszuführen.

Bei dem erfindungsgemäßen fotopolymerisierbaren Druckelement ist eine übliche fotopolymerisierbare Schicht gegebenenfalls mit einer Haftschicht auf einem dimensionsstabilen Träger aufgebracht. Beispiele geeigneter dimensionsstabiler Träger sind Platten, Folien sowie konische und zylindrische Röhren (sleeves) aus Metallen wie Stahl oder Aluminium oder aus Kunststoffen wie Polyethylenterephthalat (PET) oder Polyethylennaphthalat (PEN).

Die fotopolymerisierbare Schicht besteht aus einem fotopolymerisierbaren Gemisch, welches negativ arbeitet, d.h. durch Belichtung gehärtet wird. Dies kann durch Fotovernetzung mit vorgefertigten Polymeren, durch Fotopolymerisation von niedermolekularen, fotopolymerisierbaren Verbindungen oder beides erfolgen. Fotopolymerisierbare Schichten umfassen im wesentlichen ein polymeres, im Entwickler auswaschbares elastomeres Bindemittel, eine ethylenisch ungesättigte, radikalisch polymerisierbare Verbindung, einen Fotoinitiator oder ein Fotoinitiatorsystem sowie optional weitere Additive und Hilfsstoffe. Die Zusammensetzung derartiger Schichten ist prinzipiell bekannt und beispielsweise in DE-A 24 56 439 oder EP-A 084 851 beschrieben.

Bei dem elastomeren Bindemittel kann es sich um ein einzelnes Bindemittel oder um ein Gemisch verschiedener Bindemittel handeln. Beispiele geeigneter Bindemittel sind die bekannten Vinylaromat/Dien-Copolymere bzw. Blockcopolymere, wie beispielsweise übliche SIS- oder SBS-Blockcopolymere, Dien/Acrylnitril-Copolymere, Ethylen/Propylen/Dien-Copolymere oder Dien/Acrylat/Acrylsäure-Copolymere. Beispiele geeigneter polymerisierbarer Verbindungen sind übliche ethylenisch ungesättigte Monomere wie Acrylate oder Methacrylate von mono- oder polyfunktionellen Alkoholen, Acryl- oder Methacrylamide, Vinylether oder Vinylester. Beispiele umfassen Butyl(meth)acrylat, 2-Ethylhexyl(meth)acrylat, Butandioldi(meth)acrylat oder Hexandioldi(meth)acrylat. Als Initiatoren für die Photopolymerisation sind aromatische beispielsweise Ketoverbindungen wie Benzoin oder Benzoinderivate geeignet.

Die fotopolymerisierbaren Gemische können ferner übliche Hilfsstoffe wie beispielsweise Inhibitoren für die thermisch initiierte Polymerisation, Weichmacher, Farbstoffe, Pigmente, fotochrome Zusätze, Antioxidantien, Antiozonantien oder Extrusionshilfsmittel umfassen.

Die genaue Zusammensetzung und die Dicke der fotopolymerisierbaren Schicht wird vom Fachmann je nach den jeweiligen Anforderungen bestimmt. Es können auch mehrere, übereinander angeordnete fotopolymerisierbare Schichten gleicher oder unterschiedlicher Zusammensetzung eingesetzt werden. Weiterhin kann das Element noch zusätzliche Schichten, wie beispielsweise Haftschichten, Oberschichten oder elastische Unterschichten umfassen.

Die fotopolymerisierbaren Schichten können je nach dem verwendeten Bindemittel wässrig oder organisch entwickelbar sein. Die Vorzüge der Erfindung kommen aber besonders zum Tragen, wenn es sich um eine organisch entwickelbare Schicht handelt.

Erfindungswesentliches Element ist die neuartige Kombination mindestens zweier verschiedenartiger IR-ablativer Schichten A und B. Diese können sich direkt auf der fotopolymerisierbaren Schicht befinden, oder auch indirekt, d.h. getrennt durch eine dünne Zwischenschicht wie beispielsweise eine Haft- oder eine Sperrschicht. Bevorzugt ist die IR-ablative Schicht direkt auf der fotopolymerisierbaren Schicht aufgebracht.

Die IR-ablative Schicht A umfasst mindestens ein elastomeres Bindemittel sowie einen IR-Absorber für Laserstrahlung. Als elastomere Bindemittel können beispielsweise solche Bindemittel eingesetzt werden, die auch zur Herstellung der fotopolymerisierbaren Schicht eingesetzt werden können. Einsetzbar sind dabei insbesondere Polymere, die Dien-Einheiten umfassen, beispielsweise Polybutadien, Polyisopren oder Naturkautschuk. Mit besonderem Vorteil werden Blockcopolymere mit starren Polymerblöcken aus Styrol-, Acrylnitril oder Acrylestereinheiten und elastischen Blöcken aus Dienpolymerisaten wie z.B. von Butadien oder Isopren. Geeignet sind beispielsweise elastomere Dreiblockcopolymere mit Styrol-Isopren-Styrol- oder Styrol-Butadien-Styrol-Blöcken, wie beispielsweise in DE-A 22 15 090 beschrieben. Die Dreiblockcopolymere können als einzige Elastomere oder auch im Gemisch mit Zweiblockcopolymeren, zum Beispiel Styrol-Isopren- oder Styrol-Butadien-Zweiblockcopoymeren eingesetzt werden. Bevorzugt sind SIS-Blockcopolymere. Die Dien-Einheiten können auch ganz oder teilweise hydriert sein.

Es können auch andere Elastomere eingesetzt werden, wie beispielsweise Acrylat-Kautschuke, elastomere Polyurethane wie beispielsweise Polyetherpolyurethane oder Polyesterpolyurethane, Siliconkautschuke oder elastomere Polyamide.

Es können selbstverständlich auch Gemische zweier oder mehrerer unterschiedlicher elastomerer Bindemittel eingesetzt werden.

Die Menge an Bindemitteln in der IR-ablativen Schicht A beträgt im Regelfalle mehr als 40 bis maximal 90 Gew. % bzgl. der Menge aller Bestandteile der IR-ablativen A Schicht, bevorzugt 45 bis 80 Gew. % und ganz besonders bevorzugt 45 bis 70 Gew. %.

Die IR-ablative Schicht B umfasst mindestens ein selbst-zersetzliches Bindemittel sowie mindestens einen IR-Absorber für Laserstrahlung.

Bei dem selbst-zersetzlichen oder selbst-oxidativen Bindemittel handelt es sich um ein Bindemittel, welches sich ohne zu schmelzen unter Wärmeeinwirkung sehr leicht zersetzt oder depolymerisiert. Die entsprechenden Bildelemente weisen deswegen sehr steile Flanken auf, so dass sehr hohe Auflösungen erzielt werden können. Als selbst-zersetzlich bzw. selbst-oxidative Bindemittel können Bindemittel eingesetzt werden, die über Azid-Gruppen verfügen und ganz besonders bevorzugt solche, die über Nitro- oder Nitrat-Ester-Gruppierungen verfügen.

Beispiele geeigneter Bindemittel umfassen Polyglycidylazid, Polyglycidylnitrat oder Polyvinylnitrat, Polymere aus nitrosubstituierten Styrolen wie beispielsweise Polymere, die Nitro-, Dinitro- oder Trinitrostyrol-Gruppen umfassen. Polystyrol kann weiterhin auch in der Hauptketten nitro-substituiert sein. Weitere Beispiele umfassen Polycrylate und Polymethacrylate wie beispielsweise Polymere die 2,4-Dinitrophenylacrylate oder p-Nitrophenylacrylat als monomere Bausteine umfassen.

Insbesondere sind als selbst-zersetzliche Bindemittel Nitratester von Cellulose oder Cellulose-Derivaten, wie beispielsweise Celluloseethern geeignet. Derartige Nitratester sind auch als Nitrocellulose bekannt und kommerziell mit verschiedenen Gehalten an Nitratestergruppen erhältlich (z.B. Fa. Wolff-Walsrode), wobei der Veresterungsgrad nicht nur die Zersetzungseigenschaften, sondern auch die Löslichkeitseigenschaften der Nitrocellulose beeinflusst. Zur Ausführung der Erfindung bevorzugt sind alkohollösliche Nitrocellulosetypen. Diese sind kommerziell erhältlich und weisen üblicherweise einen N-Gehalt zwischen 10,9 und 11,3 % auf. Es können aber auch andere Typen mit höherem Stickstoffgehalt eingesetzt werden.

Es können auch Nitratester von Cellulose-Ethern wie beispielsweise Methylcellulose, Ethylcellulose und insbesondere 2-Hydroxyethyl, 2-Hydroxypropyl oder Carboxymethyl-Cellulose eingesetzt werden. Nitrierte Carboxymethyl-Cellulose kann auch als Na-Salz eingesetzt werden, wodurch die Wasserlöslichkeit erhöht wird. Es können selbstverständlich auch Mischungen verschiedener selbstzersetzlicher Bindemittel eingesetzt werden.

Die Menge an selbst-zersetzlichen Bindemitteln in der IR-ablativen Schicht B beträgt im Regelfalle mehr als 40 bis maximal 90 Gew. % bzgl. der Menge aller Bestandteile der IR-ablativen B Schicht, bevorzugt 45 bis 80 Gew. % und ganz besonders bevorzugt 45 bis 70 Gew. %.

Weiterhin umfassen beide Schichten A und B mindestens einen Absorber für Laserstrahlung.

Bei dem Absorber handelt es sich um eine in der Schicht feinverteilte Substanz. Diese sollte eine möglichst hohe Absorption zwischen 750 und 20 000 nm aufweisen. Geeignete Substanzen als Absorber umfassen im IR absorbierende Farbstoffe wie beispielsweise Phthalocyanine und Phthalocyanin-Derivate, Merocyanine oder Methin-Farbstoffe sowie stark gefärbte anorganische Pigmente wie beispielsweise Ruß, Graphit, Eisenoxide oder Chromoxide. Bevorzugt wird Ruß eingesetzt. Neben der Funktion als IR-Absorber gewährleistet Ruß gleichermaßen, dass die IR-ablative Schicht opak gegenüber aktinischer Strahlung ist, so dass es nicht unbedingt notwendig ist, zusätzlich einen UV-absorbierenden Farbstoff einzusetzen. Es ist bevorzugt, feinteilige Partikel einzusetzen, um eine möglichst maximale Farbstärke und eine möglichst gleichmäßige Schicht zu erhalten. Vorzugsweise werden feinteilige Rußsorten eingesetzt wie beispielsweise Printex® U, Printex® L6, Spezialschwarz 4 oder Spezialschwarz 250 von Degussa.

Die Menge an Absorber für die Laserstrahlung beträgt üblicherweise 1 bis 59,9 Gew. % bzgl. der Summe aller Bestandteile der Schicht, bevorzugt 10 bis 50 Gew. % und besonders bevorzugt 25 bis 50 Gew. %.

Die IR-ablativen Schichten A und B können darüber hinaus auch noch zusätzliche Hilfsmittel oder Additive umfassen. Beispiel für derartige Hilfsmittel sind Dispergierhilfsmittel für Pigmente, Füllstoffe, Weichmacher oder Hilfsstoffe zur Beschichtung. Derartige Hilfsmittel oder Additive werden vom Fachmann je nach den gewünschten Eigenschaften der Schicht ausgewählt, vorausgesetzt, sie beeinflussen die Eigenschaften der Schicht nicht nachteilig. Geeignete Dispergierhilfsmittel für Ruße sind insbesondere Polyoxyalkylen-Derivate wie beispielsweise Solperse-Typen (Fa. Avecia) oder Blockcopolymere wie Disperbyk-Typen (Byk). Es ist auch möglich, UV-Absorber als Hilfsmittel einzusetzen. Dies ist bei der Verwendung von Ruß als Absorber meist nicht unbedingt erforderlich, kann aber gelegentlich vorteilhaft sein. Bei Verwendung von IR-Farbstoffen als Absorber ist der Einsatz von zusätzlichen UV-Absorbern häufig nicht zu vermeiden, wenngleich auch nicht in jedem Falle zwingend erforderlich. Im Regelfalle sollte die Menge aller Additive und Hilfsstoffe 20 Gew. %, bevorzugt 10 Gew. % und ganz besonders bevorzugt 5 Gew. % bezüglich der Summe aller Bestandteile der IR-ablativen Schicht nicht überschreiten.

Die IR-ablativen Schichten A und B können darüber hinaus neben dem Hauptbindemittel noch mindestens ein weiteres Bindemittel anderer chemischer Natur umfassen, welches im Folgenden als sekundäres Bindemittel bezeichnet werden soll. Es können auch mehrere voneinander verschiedene Bindemittel als sekundäre Bindemittel eingesetzt werden. Die Menge des sekundären Bindemittels ist geringer als die Menge des Hauptbindemittels. Die Menge eines derartigen sekundären Bindemittels beträgt üblicherweise 0 bis 40 Gew. %, bevorzugt 0 bis 20 Gew. % und besonders bevorzugt 0 bis 10 Gew. % bzgl. aller Bestandteile der IR-ablativen Schicht.

Das sekundäre Bindemittel wird vom Fachmann je nach den gewünschten Eigenschaften der IR-ablativen Schicht ausgewählt, vorausgesetzt, die Eigenschaften der Schicht werden durch das sekundäre Bindemittel nicht negativ beeinflusst.

Die Reihenfolge der Schichten A und B ist nicht erfindungswesentlich. Die Schicht A kann als unterste Schicht, d.h. direkt auf der fotopolymerisierbaren Druckschicht angeordnet sein, und die Schicht B darüber. Besonders vorteilhaft kann aber auch die umgekehrte Schichtfolge, nämlich B-A ausgewählt werden, bei der die Schicht mit dem selbst-zersetzlichen Bindemittel zwischen die elastomere Schicht und die fotopolymerisierbare Schicht eingebettet ist. Die Schichten A und B können auch mehrfach vorhanden sein. So kann beispielsweise eine "Sandwich"-Schichtenfolge A-B-A vorliegen, bei der Schicht mit selbstoxidativem Bindemittel B zwischen zwei Schichten A eingebettet wird.

Das flexografische Druckelement kann neben den Schichten A und B auch noch weitere, vorzugsweise IR-ablative Schichten anderer Zusammensetzung aufweisen, beispielsweise Schichten C. Möglich sind dann beispielsweise die Schichtenfolge A-B-C, B-A-C oder C-B-A. Derartige Schichten C können einen ähnlichen Aufbau wie A und B aus Bindemittel und IR-Absorber aufweisen, sie können aber auch andersartig zusammengesetzt sein. Bevorzugt sind die Schichten C selbst IR-ablativ. Die Mindestanforderung ist aber, dass derartige zusätzliche Schichten die Ablation von A und B nicht stören dürfen, d.h. zumindestens mit diesen zusammen entfernbar sein müssen. Weiterhin sollten alle Schichten im Entwickler für die fotopolymerisierbare Schicht löslich oder zumindest quellbar sein.

Die Folge der Schichten A und B sowie gegebenenfalls weiterer Schichten ist im wesentlichen opak für aktinische Strahlung. Im allgemeinen beträgt die optische Dichte aller IR-ablativen Schichten zusammen im aktinischen Spektralbereich mindestens 2,5, vorzugsweise mindestens 3,0 und ganz besonders bevorzugt mindestens 3,5. Die besagte optische Dichte wird jeweils bei der Wellenlänge oder dem Wellenlängenbereich gemessen, der zur Belichtung des Elementes im Zuge der vollflächigen Bestrahlung eingesetzt wird. Die optische Dichte der Einzelschichten kann dabei durchaus ungleich sein und ist im Regelfalle jeweils für sich betrachtet geringer als 2,5. Entscheidend sind die Eigenschaften des gesamten Schichtenverbundes.

Die Gesamtdicke aller IR-ablative Schichten sollte möglichst gering sein, damit der Schichtenverbund so effizient wie möglich mittels Laserstrahlung entfernbar ist. Die Gesamtdicke der Schichtenfolge ist nach unten hin nur insofern beschränkt, als die Schichtenfolge eine optische Dichte von mindestens 2,5 aufweisen muss. Im Regelfalle ist eine Dicke von 1 bis 10 µm sinnvoll, ohne dass die Erfindung damit auf diesen Bereich beschränkt werden soll. Die Dicke der Einzelschichten, aus denen der Schichtenverbund aufgebaut ist, wird vom Fachmann je nach den gewünschten Eigenschaften festgelegt. Im Regelfalle ist aber die Dicke keiner der Einzelschichten geringer als 20 % der gesamten Dicke des Schichtenverbundes, obgleich die Erfindung nicht darauf beschränkt ist. Im Falle von zwei Schichten A und B hat sich ein Dickenverhältnis von 60:40 bis 40:60 bewährt.

Es ist empfehlenswert, das erfindungsgemäße IR-ablative Flexodruckelement durch eine flexible Schutzfolie vor Beschädigung bei Transport, Lagerung und Handling zu schützen, obgleich eine derartige Schutzfolie nicht unbedingt erforderlich ist.

Die erfindungsgemäßen fotoempfindlichen Flexodruckelemente können hergestellt werden, indem man zunächst die fotopolymerisierbare Schicht und optional weitere Schichten auf den Träger aufbringt, und anschließend die IR-ablativen Schichten A und B sowie gegebenenfalls weitere Schichten nacheinander, beispielsweise durch Aufgießen oder Auflaminieren aufträgt. Hierzu werden zunächst alle Bestandteile jeder Schicht unter intensivem Mischen in einem geeigneten Lösungsmittel oder Lösungsmittelgemisch gelöst oder dispergiert. Derartige Lösungen, bzw. Dispersionen können dann Schicht für Schicht direkt auf das fotopolymerisierbare Element aufgebracht und das Lösemittel verdampft werden. Die Lösungen können aber auch Schicht für Schicht auf eine Trägerfolie, wie beispielsweise eine PET-Folie gegossen und das jeweilige Lösemittel verdampft werden. Danach wird der beschichtete Träger unter Druck und/oder Wärmeeinfluss auf die fotopolymerisierbare Schicht laminiert. Der Träger für die IR-ablativen Schichten fungiert nun als Schutzfolie für das gesamte fotopolymerisierbare Druckelement. Bei dieser Technik muss natürlich als Erstes die oberste Schicht gegossen werden und danach die weiteren Schichten.

Die erfindungsgemäßen fotoempfindlichen Druckelemente mit mehreren IR-ablativen Schichten A und B werden zur Herstellung von Flexodruckplatten eingesetzt. Falls vorhanden wird zunächst die Schutzfolie abgezogen. Danach wird die IR-ablative Schicht bildmäßig mit einem geeigneten Laser bestrahlt um eine fotografische Maske zu erhalten. Beispiele geeigneter IR-Laser umfassen Nd/YAG-Laser (1064 nm) oder Dioden-Laser (z.B. 830 nm). Geeignete Lasersysteme für computer-to-plate-Technologie sind kommerziell erhältlich, z.B. das Dioden-Lasersystem OmniSetter® (Fa. Misomex, Wellenlänge 830 nm; Arbeitsbreite 1800 mm) oder das Nd/YAG-Lasersystem digilas® (Fa. Ohio-Schepers) welches jeweils eine zylindrische Trommel umfasst, auf welche das flexografische Druckelement mit IR-ablativer Schicht montiert wird. Die Trommel wird anschließend in Rotation versetzt und das Element mittels des Laserstrahl bebildert.

Nach Einschreiben der Maske wird das fotoempfindliche Element vollflächig mit aktinischem Licht durch die Maske hindurch belichtet. Dies kann vorteilhaft direkt auf dem Laserzylinder erfolgen. Die Platte kann aber auch abmontiert und in einer konventionellen Flachbett-Belichtungsapparatur -an Luft, unter Stickstoff oder im Vakuum- belichtet werden. Im Zuge des Belichtungsschrittes wird die Schicht an solchen Stellen, die im vorangehenden Verfahrensschritt durch IR-Ablation freigelegt wurden, fotochemisch vernetzt, während die nach wie vor abgedeckten Stellen unvernetzt bleiben.

In einem weiteren Verfahrensschritt wird das belichtete Element entwickelt. Das Entwickeln kann prinzipiell in handelsüblichen Entwicklerapparaturen unter Verwendung handelsüblicher Auswaschmittel für Flexodruckplatten wie beispielsweise nylosolv® oder Optisol® durchgeführt werden. Im Zuge der Entwicklung werden die nicht belichteten Anteile der fotopolymerisierbaren Schicht sowie die Reste der IR-ablativen Schicht entfernt. Es wird bevorzugt nur ein einziges Auswaschmittel für diesen Verfahrensschritt eingesetzt. Es ist aber auch möglich, zunächst die Reste der IR-ablativen Schicht mit einem Auswaschmittel zu entfernen und anschließend die Platte in einem zweiten Auswaschmittel zu entwickeln. Nach dem Entwickeln werden die erhaltenen Flexodruckplatten in bekannter Art und Weise getrocknet. Das Verfahren kann weitere Verfahrensschritte, wie beispielsweise eine Entklebung mit UV-C oder Br₂ umfassen.

Die erfindungsgemäßen Flexodruckelemente mit mehreren IR-ablativen Schichten weisen eine Reihe von Vorteilen auf:

Die Empfindlichkeit für Laserstrahlung erreicht zwar nicht die von reinen Nitrocellulose-Schichten, ist aber dennoch höher als die kommerziell erhältlicher Platten. Durch die Kombination einer elastomeren Schicht A mit einer Schicht mit selbstzersetzlichem Bindemittel B wie insbesondere Nitrocellulose wird einerseits ein sehr empfindliches Flexodruckelement erhalten, welches dennoch eine überraschend hohe Elastizität aufweist. Derartige Flexodruckplatten lassen sich problemlos um die Trommeln von Laserbelichtern legen, ohne dass die Schicht reisst oder runzelt. Die Menge an Weichmacher in der Nitrocellulose-Schicht läßt sich gegenüber reinen Nitrocellulose-Platten deutlich verringern. Besonders deutlich sind die Vorteile, wenn sich die IR-ablative Schicht mit dem elastomeren Bindemittel an oberster Stelle befindet. Die Schichtoberfläche ist klebfrei und die Schutz- bzw. Deckfolienhaftung gering, so dass die Schutzfolie ohne Probleme angezogen werden kann. Die Haftung auf der fotopolymerisierbaren Schicht ist hoch, so dass die IR-ablative Schicht auch bei schnellem und unvorsichtigem Abziehen der Schutzfolie auf der fotopolymerisierbaren Schicht haften bleibt. Die Schichten sind mit üblichen organischen Auswaschmitteln wie bspw. nylosolv® abwaschbar.

Die folgenden Beispiele sollen die Erfindung beispielhaft erläutern.

Allgemeine Vorschrift zur Herstellung einer Dispersion von IR-Absorber und Bindemittel

Ein Dispergierhilfsmittel (Solsperse 20 000) wird im Lösemittelgemisch vorgelöst. Anschließend werden das/die Bindemittel A wie gegebenenfalls weitere Additive zugegeben und unter Rühren gelöst. Dann wird der Ruß langsam zugegeben und 15 min bei einer Geschwindigkeit von 5000 U/min am Dissolver eindispergiert. Die erhaltene Mischung wird 1h in einer Laborrührwerkskugelmühle gemahlen. Die Dispersion hat einen Feststoff-Gehalt von 10 Gew. % bezüglich der Summe aller Bestandteile.

In gleicher Art und Weise wird eine Dispersion der festen Bestandteile der Schicht B in einem geeigneten Lösungsmittel erzeugt.

Zunächst wird entweder Dispersion A oder Dispersion B am Laborrakel auf eine PET-Folie aufgerakelt und 10 min bei 60 °C getrocknet. Anschließend wird die verbliebene Dispersion unter gleichen Bedingungen aufgebracht und getrocknet.

Die optische Dichte eines derartigen Films im Spektralbereich des aktinischen Lichts beträgt 3.0 bis 3.5.

Von einer kommerziellen Flexodruckplatte vom Typ FAH 254 (BASF) wird die Schutzfolie und die Substratschicht entfernt, so dass die Oberfläche der fotopolymerisierbaren Schicht freigelegt ist. Die mit dem IR-ablativen Schichtenverbund beschichtete PET-Folie wird auf die Oberfläche der fotopolymerisierbaren Schicht trocken aufkaschiert, so dass der IR-ablative Schichtenverbund und die fotopolymerisierbare Schicht miteinander verbunden werden. Die PET-Folie bildet die Schutzfolie. Die Platte lagert 1 Woche bei Raumtemperatur.

### Beispiele 1:

Es wurde eine Dispersion B für die IR-ablative Schicht B aus 35 Gew.% Ruß, 3 Gew. % Dispergierhilfsmittel (Solperse 20000), 52 Gew.% Nitrocellulose (Typ A 400, Wolff-Walsrode, 10 Gew. % Weichmacher (Plasthall 41 41 (CP Hall)) (Angaben jeweils bezüglich der Gesamtmenge alle Bestandteile der getrockneten Schicht) in einem Lösemittelgemisch aus Toluol, Propanol, Benzylalkohol und Essigester wie beschrieben hergestellt (10 Gew. % Feststoffgehalt).

Es wurde eine Dispersion A für die IR-ablative Schicht A aus 35 Gew.% Ruß, 3 Gew. % Dispergierhilfsmittel (Solperse 20000), 62 Gew.% eines elastomeren Bindemittel (elastomeres Polyetherpolyurethan, Surkofilm 72 S, Fa. Mitchanol, Angaben jeweils bezüglich der Gesamtmenge alle Bestandteile der getrockneten Schicht) in einem Lösemittelgemisch aus Ethanol, Essigester und Benzylalkohol wie beschrieben hergestellt. (10 Gew. % Feststoffgehalt). Die Einsatzstoffe und Mengen sind auch in Tabelle 1 zusammengefasst.

Zunächst wurde die Dispersion A auf die PET-Folie aufgegossen und getrocknet, dann die Dispersion B. Der erhaltene Schichtenverbund wurde wie beschrieben auf die Flexodruckplatte aufkaschiert. Die Dicke des Schichtenverbundes betrug etwa 2,5 µm; die beiden Teilschichten waren gleich dick.

Von den erhaltenen Platten wurden die Deckfolienhaftung, die Substrathaftung, die Elastizität und die Klebrigkeit der IR-ablativen Schicht bestimmt. Die Messvorschriften für die Messgrößen sind in Tabelle 3 aufgeführt, die Ergebnisse in Tabelle 2 zusammengefasst.

### Beispiele 2 und 3:

Es wurde wie in Beispiel 1 vorgegangen, nur wurden andere elastomere Bindemittel eingesetzt.

### Vergleichsbeispiele V1:

Es wurde wie in Beispiel 1 vorgegangen, nur wurde auf die Schicht A verzichtet, und es wurde nur die Nitrocellulose-haltige Schicht B gegossen. Die Dicke der Schicht B betrug etwa 2,5 µm.

### Vergleichsbeispiel V2:

Es wurde wie in V1 vorgegangen, nur wurde statt des alkohollöslichen Nitrocellulose Typs A 400 der esterlösliche Typ E 900 eingesetzt (jeweils Fa. Wolff-Walsrode).

Bebilderung mittels Laser, Verarbeitung zur Flexodruckplatte, allgemeine Vorschrift

Die PET-Schutzfolie der Flexodruckelemente mit IR-ablativem Schichtenverbund wird entfernt und die Platte auf die rotierbare Trommel (Durchmesser: 0,25 m) eines Nd-YAG-Lasersystemes (Fa Schepers/Ohio, digilas®) montiert. Die Trommel wird bis auf 1600 Upm beschleunigt. Der Laservorschub beträgt 10 µm pro Trommelumdrehung.

In einem ersten Versuch wird bei jeder Platte zunächst die Laserleistung ermittelt, die bei besagter Drehzahl und Vorschub zum vollständigen Entfernen der IR-ablativen Schicht an den Stellen, an denen sie vom Laserstahl getroffen wird, mindestens erforderlich ist. Aus der notwendigen Laserleistung lässt sich die Empfindlichkeit der Platte in J/m² berechnen; also die Mindestenergie pro Fläche, die zur Entfernung der Schicht erforderlich ist. Die Empfindlichkeit ist umso höher, je kleiner die Mindestenergie ist.

In einem weiteren Versuch wird jede Platte mit der ermittelten Laserleistung digital bebildert. Das erhaltene fotopolymerisierbare Flexodruckelement mit digitaler Maske wird 15 min mit aktinischem Licht in konventioneller Art und Weise bestrahlt und anschließend in konventioneller Art und Weise in einem Bürstenwascher unter Verwendung des kommerziellen (organischen) Auswaschmittels nylosolv® II entwickelt. Nach dem Entwickeln wird die Platte für 2 Stunden bei 60°C getrocknet, mit UV-C-Licht zur Entklebung bestrahlt und schließlich für 10 min mit aktinischem Licht nachvernetzt.

### Beispiele 1 - 3 und Vergleichsbeispiele V1 - V2

Es wurden jeweils die hergestellten flexografischen Druckelemente eingesetzt. Die jeweils ermittelte Laserleistung bzw. die Empfindlichkeit ist in Tabelle 2 angegeben. Weiterhin wurde die Abwaschbarkeit bzw. Entfernbarkeit der IR-ablativen Schicht im Auswaschmittel ermittelt. Die Ergebnisse sind in Tabelle 2 aufgeführt, die Messvorschrift ist in Tabelle 3 enthalten.

### Vergleichsbeispiele V 3 - V 6

Von 4 kommerziell erhältlichen Flexodruckelementen mit IR-ablativer Schicht wurden wie oben geschildert die mechanischen Eigenschaften, die Empfindlichkeit und die Verarbeitungseigenschaften ermittelt. Die Ergebnisse sind ebenfalls in Tabelle 2 aufgeführt.

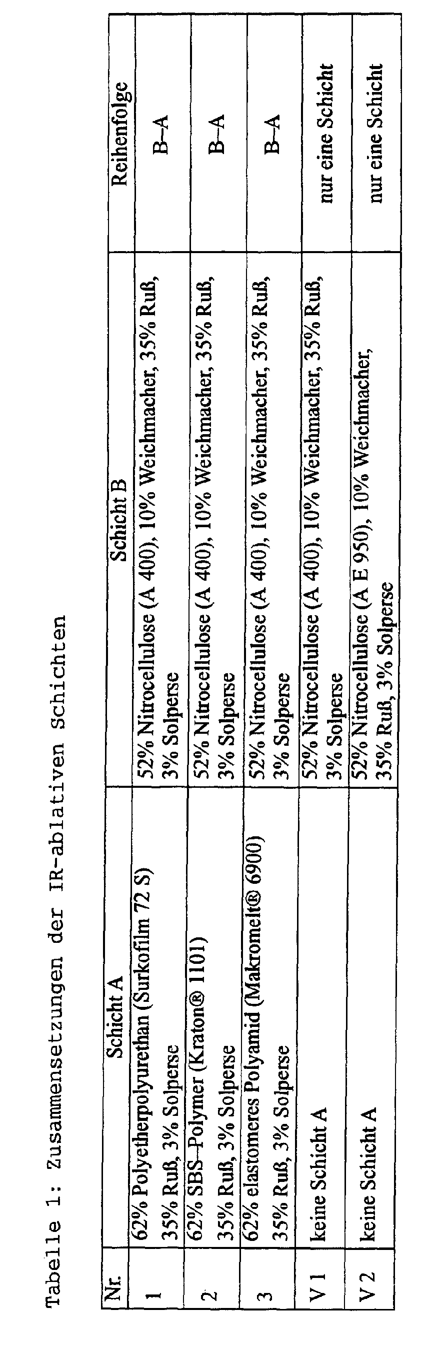

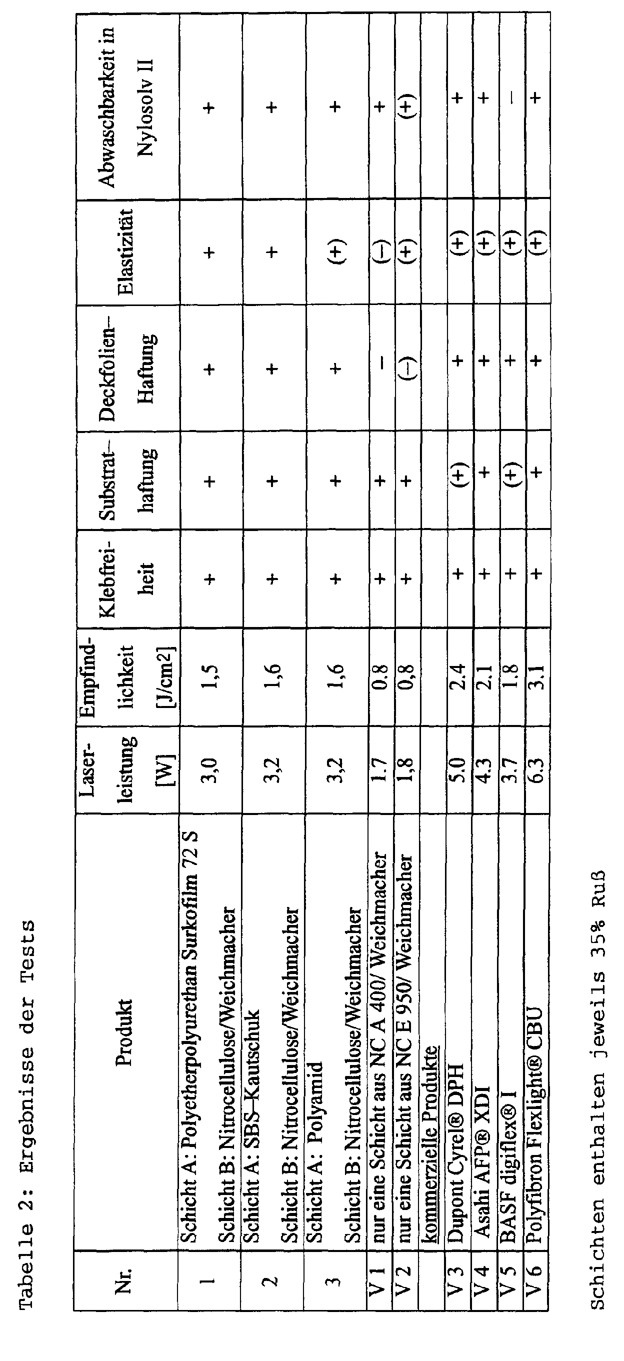

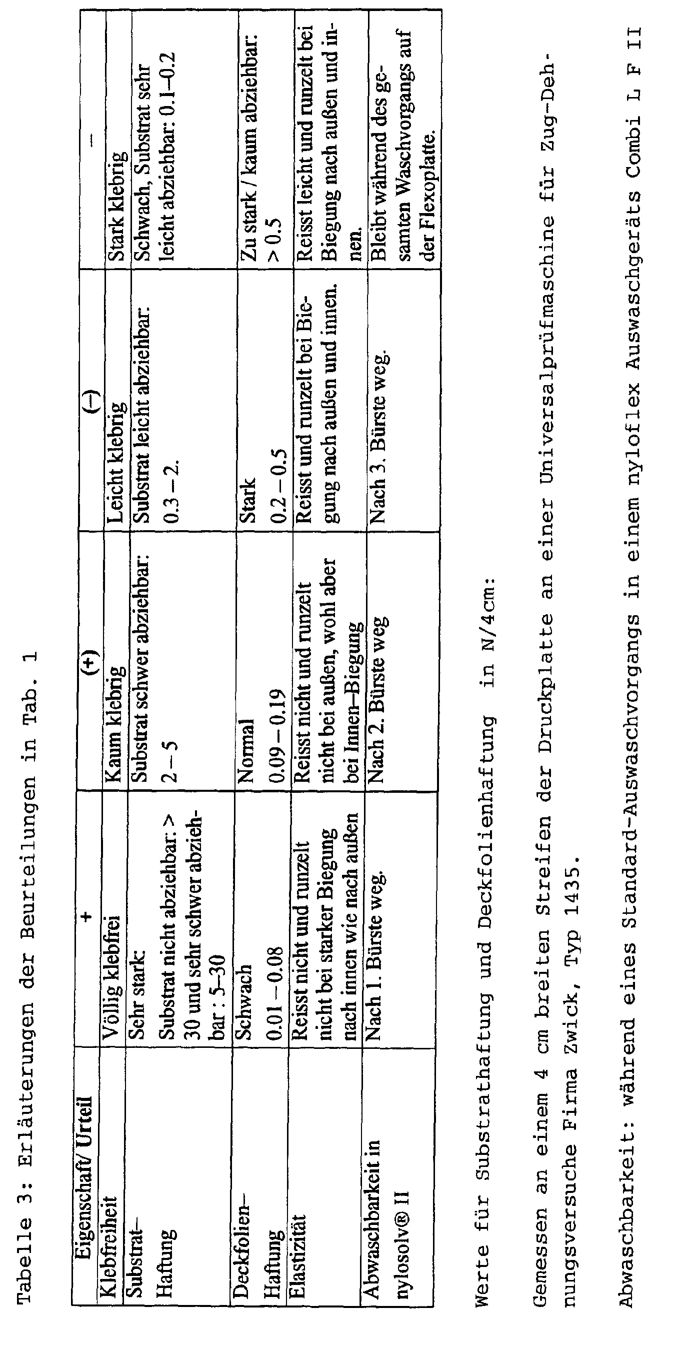

Die Beispiele und Vergleichsbeispiele zeigen, dass flexografische Druckelemente erhalten werden, die die Anforderungen in hervorragender Art und Weise erfüllen. Die erfindungsgemäßen Flexodruckelemente mit mindestens zwei IR-ablativen Schichten weisen weiterhin den Vorteil auf, dass hierbei auch alkohollösliche Nitrocellulose-Typen eingesetzt werden können, die auch sehr gut in gängigen Entwicklern für Flexodruckplatten löslich sind. Aufgrund ihrer hohen Deckfolienhaftung war der Einsatz derartiger Typen bei den bekannten einschichtigen Systeme nicht möglich. Die Erfindung eröffnet die Möglichkeit, auch solche Typen zu einzusetzen.

## Patentansprüche

1. Fotoempfindliches Flexodruckelement zur Herstellung von Flexodruckformen durch digitale Bebilderung mittels Lasern, mindestens umfassend
• einen dimensionsstabilen Träger,
• mindestens eine fotopolymerisierbare Schicht, mindestens umfassend ein elastomeres Bindemittel, eine polymerisierbare Verbindung und einen Fotoinitiator oder ein Fotoinitiatorsystem,
• mindestens zwei laser-ablatierbare Schichten A und B, die jeweils mindestens ein Bindemittel sowie einen IR-Absorber für Laserstrahlung aufweisen, sowie
• optional eine abziehbare, flexible Schutzfolie,
**dadurch gekennzeichnet, dass** es sich bei dem mindestens einen Bindemittel der Schicht A um ein elastomeres Bindemittel und dem mindestens einen Bindemittel der Schicht B um ein selbst-zersetzliches Bindemittel handelt, und die optische Dichte der gesamten Schichtenfolge IR-ablativer Schichten im aktinischen Spektralbereich mindestens 2,5 beträgt.

2. Fotoempfindliches Flexodruckelement gemäß Anspruch 1, **dadurch gekennzeichnet, dass** das selbst-zersetzliche Bindemittel der Schicht B Nitro- und/oder Nitratestergruppen umfasst.

3. Fotoempfindliches Flexodruckelement gemäß Anspruch 2, **dadurch gekennzeichnet, dass** es sich bei dem Nitro- und/oder Nitratestergruppen umfassenden Bindemittel um einen Nitratester von Cellulose oder Celluloseethern handelt.

4. Fotoempfindliches Flexodruckelement gemäß einem der Ansprüche 1 bis 3, **dadurch gekennzeichnet, dass** es sich bei dem elastomeren Bindemittel um ein Dien-Einheiten umfassendes Bindemittel handelt.

5. Fotoempfindliches Flexodruckelement gemäß einem der Ansprüche 1 bis 4, **dadurch gekennzeichnet, dass** es sich bei dem IR-Absorber um Ruß handelt.

6. Fotoempfindliches Flexodruckelement gemäß einem der Ansprüche 1 bis 5, **dadurch gekennzeichnet, dass** das flexografische Druckelement noch weitere IR-ablative Schichten umfasst.

7. Verfahren zur Herstellung einer flexografischen Druckform, bei der man als Ausgangsmaterial ein fotoempfindliches Flexodruckelement nach einem der Ansprüche 1 - 6 einsetzt, umfassend die folgenden Schritte:
(a) Entfernen der abziehbaren, flexiblen Schutzfolie, falls vorhanden,
(b) Einschreiben einer Maske in den Schichtenverbund aus IR-ablativen Schichten mittels eines IR-Lasers,
(c) vollflächiges Belichten des fotoempfindlichen Elementes mit aktinischem Licht durch die in Schritt (b) gebildete Maske,
(d) Behandeln des in (c) gebildeten Zwischenproduktes mit zumindest einer Entwickler-Lösung, wobei die Reste der IR-ablativen Schichten, die im Schritt (b) nicht entfernt worden sind entfernt werden und die belichtete, fotopolymerisierbare Schicht entwickelt wird.

8. Verfahren gemäß Anspruch 7, **dadurch gekennzeichnet, dass** man zur Durchführung des Schrittes (b) eine Laserapparatur mit einer rotierenden Trommel verwendet und das flexografische Druckelement zum Ablatieren auf diese Trommel montiert wird.
